(19) Europäisches Patentamt
European Patent Office
Office européen des brevets

(11) **EP 2 840 404 B1**

(12) **EUROPÄISCHE PATENTSCHRIFT**

(45) Veröffentlichungstag und Bekanntmachung des Hinweises auf die Patenterteilung:
**23.03.2016 Patentblatt 2016/12**

(51) Int Cl.:
*G01R 31/02* (2006.01)   *H05B 1/02* (2006.01)
*F24H 9/20* (2006.01)   *F24H 1/10* (2006.01)
*H02H 3/16* (2006.01)

(21) Anmeldenummer: **13181085.5**

(22) Anmeldetag: **20.08.2013**

(54) **Elektrischer Blankdrahtdurchlauferhitzer und Verfahren zur Steuerung desselben**

Electrical bare element continuous flow heater and method for controlling the same

Chauffe-eau électrique instantané à fil nu et procédé de commande de celui-ci

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.02.2015 Patentblatt 2015/09**

(73) Patentinhaber: **Gerdes OHG**
**21337 Lüneburg (DE)**

(72) Erfinder:
• **Hagemann, Jannes**
**21379 Scharnebeck (DE)**
• **Von Seth, Hans-Joachim**
**21406 Melbeck (DE)**
• **Koch, Christian**
**21403 Wendisch Evern (DE)**

(74) Vertreter: **Stork Bamberger**
**Patentanwälte**
**Postfach 73 04 66**
**22124 Hamburg (DE)**

(56) Entgegenhaltungen:
WO-A1-03/016791   WO-A1-2011/082452
DE-A1- 4 308 231   US-A- 4 093 847
US-A- 6 080 971   US-A1- 2013 015 172

**Beschreibung**

Die vorliegende Erfindung betrifft einen elektrischen Blankdrahtdurchlauferhitzer zur Warmwasserbereitung, umfassend eine Kanalanordnung mit einem elektrisch leitfähigen und mit dem Erdpotential elektrisch leitend verbundenen Wasserzulaufkanal, der zum Anschluss an eine erste äußere, Wasser zuführende Wasserleitung eingerichtet ist und einem elektrisch leitfähigen und mit dem Erdpotential elektrisch leitend verbundenen Wasserablaufkanal, der zum Anschluss an eine zweite äußere, Wasser abführende Wasserleitung eingerichtet ist, wobei die Kanalanordnung mindestens einen Wasser führenden elektrisch nicht-leitfähigen Kanal umfasst, an dessen Kanalenden jeweils der Wasserzulaufkanal und der Wasserablaufkanal angeordnet sind, eine zum Erwärmen von durch die Kanalanordnung fließendem Wasser eingerichtete elektrische Blankdrahtheizeinrichtung, eine zum Regeln der Heizleistung der Blankdrahtheizeinrichtung eingerichtete elektronische Steuereinrichtung, wobei die Steuereinrichtung eine Leitfähigkeitsmesseinrichtung zur Bestimmung eines Leitfähigkeitswertes des durch die Kanalanordnung fließenden Wassers umfasst. Des Weiteren umfasst die vorliegende Erfindung ein Verfahren zum Steuern eines elektrischen Blankdrahtdurchlauferhitzers.

Derartige elektrische Blankdrahtdurchlauferhitzer sind aus dem Stand der Technik hinlänglich bekannt. Bei den eingangs genannten Blankdrahtdurchlauferhitzern wird das zu erwärmende Wasser durch Kanäle einer Kanalanordnung geführt. In mindestens einem der Kanalabschnitte befindet sich eine Heizeinrichtung mit einem Blankdraht, d. h. mit einem elektrisch nicht isolierten Heizdraht, der unmittelbar mit dem ihn umströmenden Wasser in Kontakt gelangt. Wasserzulauf- und Wasserablaufanschlüsse des Blankdrahtdurchlauferhitzers werden durch elektrisch leitende Kanäle gebildet, die jeweils mit dem Erdpotential elektrisch leitend verbunden sind. Die Potentialdifferenz zwischen dem Blankdraht und den mit dem Erdpotential elektrisch leitend verbundenen Wasserzulaufkanal bzw. dem Wasserablaufkanal führt während des Betriebs der Heizeinrichtung zu entsprechenden Ableitströmen. Die Größe dieser Ableitströme hängt insbesondere vom Kanalquerschnitt, der Kanallänge, der Bauart der Kanalanordnung und der Leitfähigkeit des durch die Kanäle fließenden Wassers ab.

Aus der deutschen Gebrauchsmusterschrift DE 84 28 975 ist ein Heißwasser-Durchlauferhitzer bekannt, bei dem die Leitfähigkeit des das Gerät durchströmenden Wassers gemessen wird. In Abhängigkeit von diesem Messwert wird der Heizstrom einer Heizspirale nur dann eingeschaltet, wenn die Leitfähigkeitsmessung ergibt, dass sich ausreichend Wasser im Strömungskanal des Durchlauferhitzers befindet. Auf diese Weise kann ein möglicher Wassermangel im Durchlauferhitzer erkannt und das Einschalten der Heizspirale bei Wassermangel verhindert bzw. während des Betriebes die Heizspirale unmittelbar ausgeschaltet werden, sofern ein Wassermangel detektiert worden ist. DE 8 428 975 U wird als nächstliegender Stand der Technik angesehen und offenbart alle Merkmale des Präambels der Ansprüche 1 und 11.

Nachteilig ist, dass das mit der Leitfähigkeitsmessung gemäß dem aus dem Dokument DE 84 28 975 bekannten Durchlauferhitzer ausschließlich ein Wassermangel erkannt wird, um die Heizspirale in diesem Fall abzuschalten und so eine Überhitzung der Heizspirale, die ggf. mit einer Zerstörung derselben einhergeht, zu verhindern.

Der vorliegenden Erfindung liegt daher die Aufgabe zugrunde, einen elektrischen Blankdrahtdurchlauferhitzer vorzuschlagen, der selbsttätig die Einhaltung eines vorgegebenen Ableitstromgrenzwertes überwacht und steuert bzw. regelt.

Die vorliegende Aufgabe wird dadurch gelöst, dass die Steuereinrichtung eine zum Ermitteln eines hypothetischen Ableitstromwertes auf Basis des Leitfähigkeitswertes und mindestens einem, vorgegebenen, bauartbedingten Geräteparameter eingerichtete Auswerteeinheit umfasst und die Steuereinrichtung angepasst ist, die Heizleistung der Blankdrahtheizeinrichtung zu reduzieren, sofern der hypothetische Ableitstromwert einen vorgegebenen Ableitstromschwellwert übersteigt. Durch die Ermittlung des hypothetischen Ableitstromwertes ist es möglich, den tatsächlich gegen Erde fließenden Ableitstrom in Abhängigkeit des Leitfähigkeitswertes und des Geräteparameters exakt zu bestimmen und erst im Falle einer Überschreitung des vorgegebenen Ableitstromschwellwertes durch die Reduktion der Heizleistung der Blankdrahtheizeinrichtung den tatsächlich gegen Erde fließenden Ableitstrom zu reduzieren. Die Reduktion der Heizleistung kann dabei auf vielfältige Weise erfolgen, beispielsweise durch vollständiges oder teilweises Abschalten der Heizeinrichtung, Reduzieren der an die Heizeinrichtung angelegten Betriebsspannung, Leistungsreduktion durch Halbwellen und-/oder Phasenanschnittsteuerung. Die Steuereinrichtung ist hierzu entsprechend eingerichtet, um den hypothetischen Ableitstromwert basierend auf dem mittels der Leitfähigkeitsmesseinrichtung bestimmten Leitfähigkeitswert und dem bauartbedingten Geräteparameter zu ermitteln. Der bauartbedingte Geräteparameter umfasst beispielsweise eine gerätespezifische Konstante, die einen Zusammenhang zwischen dem Leitfähigkeitswert und dem zu erwartenden Ableitstrom bei einem Blankdrahtdurchlauferhitzer einer bestimmten Bauart darstellt. Der bauartbedingte Geräteparameter hängt beispielsweise von dem Kanalquerschnitt der Kanalanordnung, der Länge des elektrisch nicht-leitenden Kanals, von der Geometrie und dem Einbauort der Blankdrahtheizeinrichtung sowie der Anzahl der Blankdrahtheizeinrichtungen ab. Durch Vorgabe des Geräteparameters für einen jeden Blankdrahtdurchlauferhitzertyp kann mittels der Auswerteeinheit der Steuereinrichtung aus dem Leitfähigkeitswert der hypothetische Ableitstromwert ermittelt werden, ohne dass es der Messung des tatsächlichen fließenden Ableitstromes bedarf. Der Wasserzulaufkanal und der Wasserablaufkanal umfassen bevorzugt jeweils ein Wasserleitungsanschlussstück und einen Zulauf- bzw. einen Ablaufkanal. Mit anderen Worten wird der Wasserzulaufkanal durch eines der Wasseranschlussstücke und dem Zulaufkanal gebildet, während der Wasserablaufkanal aus einem Wasserleitungsanschlussstück und dem Ablaufkanal gebildet wird. Besonders bevorzugt sind jeweils die Wasseranschlussstücke aus einem elektrisch leitfähigen Material, beispielsweise aus Messing gebildet, während der Zulauf- und der Ablaufkanal aus einem elektrisch nicht-leitfähigen Material sind. Alternativ sind der Zulauf- und der Ablaufkanal ebenfalls aus einem elektrisch leitfähigen Material gebildet.

Vorzugsweise umfasst die Steuereinrichtung einen digitalen Mikrocomputer, der eingerichtet ist, den Leitfähigkeitsmesswert nach Analog-/Digitalwandlung eines zur Leitfähigkeit korrespondierenden Spannungswertes mittels eines Analog-/Digitalwandlers digital zu verarbeiten. Alternativ umfasst die Steuereinrichtung analoge Baugruppen, die zur rein analogen Verarbeitung des Leitfähigkeitsmesswertes eingerichtet und ausgebildet sind. Weiter bevorzugt umfasst die Steuereinrichtung gemischte Baugruppen, d.h. sowohl analoge als auch digitale Schaltungskomponenten.

Eine vorteilhafte Weiterbildung der Erfindung zeichnet sich dadurch aus, dass die Steuereinrichtung mindestens einen ersten Temperaturfühler zum Messen einer Wassertemperatur des durch die Kanalanordnung fließenden Wassers umfasst und die Auswerteeinheit eingerichtet ist, den hypothetischen Ableitstromwert bei einer vorgegebenen Bezugstemperatur ferner auf Basis der mittels des Temperaturfühlers gemessenen Wassertemperatur zu ermitteln. Dies bietet den Vorteil, dass der Einfluss der Wassertemperatur bei der Bestimmung des hypothetischen Ableitstromwertes Berücksichtigung findet und so ein vorgegebener Ableitstromschwellwert bei einer definierten Bezugstemperatur präzise eingehalten werden kann. Üblicherweise wird gefordert, dass der tatsächliche Gesamtableitstrom bei einer vorgegebenen Bezugstemperatur des Wassers, beispielsweise bei 15°C, einen vorgegebenen Ableitstromschwellwert, beispielsweise in Höhe von typisch 5 mA nicht überschreitet. Grundsätzlich steigt der Leitwert von Wasser mit steigender Temperatur an, so dass beim Betrieb des Blankdrahtdurchlauferhitzers mit Wasser einer höhen Temperatur als der Bezugstemperatur ein höher hypothetischer Ableitstrom mittels der Auswerteeinrichtung ermittelt würde.

Gemäß einer bevorzugten Weiterbildung der Erfindung ist die Auswerteeinheit angepasst, den Leitfähigkeitswert bei der vorgegebenen Bezugstemperatur aus der mittels der Leitfähigkeitsmesseinrichtung gemessenen Leitfähigkeit des Wassers und der Wassertemperatur zu bestimmen. Dies bietet den Vorteil, dass bereits die gemessen Leitfähigkeit des Wassers mittels der Auswerteeinheit auf die Bezugstemperatur normiert wird und so ein entsprechender auf die Bezugstemperatur angepasster Leitfähigkeitswert ermittelt wird. Mit anderen Worten ist die Auswerteeinheit angepasst, den Leitfähigkeitswert des Wassers bei der Bezugstemperatur zu bestimmen. Beträgt die Wassertemperatur beispielsweise 30°C, während die Bezugstemperatur 15°C beträgt, so ist die mittels der Leitfähigkeitsmesseinrichtung gemessene Leitfähigkeit des Wassers aufgrund der mit der Temperatur ansteigenden Leitfähigkeit des Wassers größer, als die Leitfähigkeit, die das Wasser bei einer Bezugstemperatur von 15°C aufweisen würde.

Eine weitere vorteilhafte Ausgestaltung ist dadurch gekennzeichnet, dass der erste Temperaturfühler in einem Wasserzulaufbereich zum Messen einer Wasserzulauftemperatur angeordnet ist. So wird vorteilhafter Weise die Temperatur des zu erwärmenden Wasser beim Einlauf in den Blankdrahtdurchlauferhitzer gemessen. Dies ist insbesondere dann vorteilhaft, wenn der Blankdrahtdurchlauferhitzer zur Nacherwärmung von bereits vorgewärmtem Brauchwasser zum Einsatz kommt und/oder die Wasserzulauftemperatur starken Temperaturschwankungen unterworfen ist. Der Wasserzulaufbereich umfasst sowohl den Wasserzulaufkanal als auch einen Teilbereich des Wassers führenden nicht-leitfähigen Kanals, nämlich den Bereich der Kanalanordnung, der sich bezüglich der Fließrichtung des Wassers vor der ersten Blankdrahtheizeinrichtung befindet.

Gemäß einer bevorzugten Weiterbildung der Erfindung umfasst die Steuereinrichtung mindestens einen zweiten in einem Wasserablaufbereich angeordneten Temperaturfühler zum Messen einer Wasserauslauftemperatur. Die Auswerteeinheit ist vorzugweise eingerichtet, den hypothetischen Ableitstromwert bei einer vorgegebenen Bezugstemperatur ferner auf Basis der mittels des zweiten Temperaturfühlers gemessenen Wasserauslauftemperatur zu ermitteln. Auf diese Weise wird der hypothetische Ableitstrom mit hoher Präzision ermittelt. Mittels des zweiten in dem Wasserablaufbereich angeordneten Temperaturfühlers wird die Wassertemperatur des durch die Blankdrahtheizeinrichtung bzw. durch die Blankdrahtheizeinrichtungen erwärmten Wassers gemessen. Die Auswerteeinheit ist einerseits eingerichtet, ausgehend von dieser Wassertemperatur einen hypothetischen ersten Teilableitstrom, der zwischen der Blankdrahtheizeinrichtung und dem Wasserablaufkanal gegen Erde fließt, zu ermitteln. Andererseits ist die Auswerteeinheit dazu ausgebildet, einen hypothetischen zweiten Teilableitstrom, der zwischen der Blankdrahtheizeinrichtung und dem Wasserzulaufkanal gegen Erde fließt, auf Basis der Wassereinlauftemperatur zu ermitteln. Die Auswerteeinheit ist ferner dazu eingerichtet, den hypothetischen Ableitstrom, d.h. den hypothetischen Gesamtableitstrom, der sich aus der Summe der ersten und zweiten Teilableitströme ergibt, zu ermitteln. Der Wasserablaufbereich umfasst sowohl den Wasserablaufkanal als auch einen Teilbereich des Wasser führenden nicht-leitfähigen Kanals, also den Bereich der Kanalanordnung, der sich bezüglich der Fließrichtung des Wassers nach der letzten Blankdrahtheizeinrichtung befindet.

Eine weitere bevorzugte Ausbildung der Erfindung zeichnet sich dadurch aus, dass die Leitfähigkeitsmesseinrichtung zwei Elektroden umfasst, die jeweils mit dem durch die Kanalanordnung fließendem Wasser in Kontakt stehen. Die so gebildete Leitfähigkeitsmesseinrichtung zeichnet sich durch eine besonders einfache Bauart und hohe Zuverlässigkeit im Betrieb aus. Bevorzugt sind die Elektroden Teil eines ohmschen Spannungsteilers, der mit einer Gleichspannung beaufschlagt wird. Änderungen der Leitfähigkeit des Wassers führen zu einer Veränderung des elektrischen Widerstandes zwischen den beiden Elektroden, so dass sich die Spannungsverhältnisse am Spannungsteiler entsprechend verändern. Die Auswerteeinrichtung ist entsprechend angepasst und eingerichtet, um die Spannungsverhältnisse zu verarbeiten und daraus den Leitfähigkeitswert des Wassers zu ermitteln.

Gemäß einer weiteren bevorzugten Ausbildung der Erfindung ist eine der Elektroden in Fließrichtung des Wassers vor der Blankdrahtheizeinrichtung und die jeweils andere der Elektroden in Fließrichtung des Wassers nach der Blankdrahtheizeinrichtung angeordnet. Vorteilhafter Weise wird so ein Großteil der gesamten Wasser führenden Strecke der Kanalanordnung als Ausgangsbasis zur Bestimmung des Leitfähigkeitswertes genutzt.

Eine weitere bevorzugte Ausführung der Erfindung ist dadurch gekennzeichnet, dass zumindest eine der Elektroden durch den Wasserzulaufkanal oder durch den Wasserablaufkanal gebildet ist. Auf diese Weise wird der Fertigungsaufwand deutlich reduziert, da jeweils die bereits vorhandenen elektrisch leitfähigen Wasserzu- und Wasserablaufkanäle selbst jeweils eine der Elektroden bilden.

Gemäß einer besonders bevorzugten Ausführung der Erfindung ist zumindest eine der Elektroden durch die Blankdrahtheizeinrichtung gebildet. Mit anderen Worten übernimmt die Blankdrahtheizeinrichtung die Funktion einer der Elektroden, wodurch der Herstellungsaufwand ebenfalls reduziert ist, da keine separate Elektrode in die Kanalanordnung eingebracht werden muss. Ein weiterer Vorteil besteht darin, dass eine der Zuleitungen, mit denen die Blankdrahtheizeinrichtung mit der zum Erwärmen des Wasser erforderlichen Betriebsspannung versorgt werden, zugleich als Anschluss einer der Elektroden genutzt wird und der Verkabelungsaufwand im Gerät nochmals reduziert ist.

Eine weitere vorteilhafte Ausbildung der Erfindung zeichnet sich dadurch aus, dass die Elektroden der Leitfähigkeitsmesseinrichtung über mindestens ein Trennmittel spannungsfrei schaltbar sind. Dies bietet den Vorteil, dass zwischen den beiden Elektroden jeweils nur während der Durchführung einer Leitfähigkeitsmessung eine Messspannung anliegt. Während der übrigen Zeit liegt zwischen den Elektroden keine Spannung an, so dass unerwünschte elektrolytische Vorgänge an den Elektroden vermieden werden.

Die Aufgabe wird auch durch das eingangs genannte Verfahren gelöst, das sich auszeichnet durch Bestimmen eines Leitfähigkeitswertes von durch eine Kanalanordnung des Blankdrahtdurchlauferhitzers fließenden Wassers, Ermitteln eines hypothetischen Ableitstromwertes auf Basis des Leitfähigkeitswertes und mindestens einem vorgegebenen, bauartbedingten Geräteparameter, Vergleichen des hypothetischen Ableitstromwertes mit einem vorgegebenen Ableitstromschwellwert und sofern der hypothetische Ableitstromwert den vorgegebenen Ableitstromschwellwert übersteigt, Reduzieren der Heizleistung einer Blankdrahtheizeinrichtung des Blankdrahtdurchlauferhitzers.

Zur Vermeidung von Wiederholungen wird im Zusammenhang mit dem erfindungsgemäßen Verfahren auf die zuvor gemachten Ausführungen des erfindungsgemäßen elektrischen Blankdrahtdurchlauferhitzers verwiesen. In den entsprechenden Textpassagen sind die Funktionen der Steuereinrichtung und der der Auswerteeinheit bereits beschrieben, die jeweils auch auf die verfahrensgegenständlichen Merkmale zutreffen. Die hier zum erfindungsgemäßen Verfahren gemachten Ausführungen gelten daher jeweils in Ergänzung zu Obigem.

Durch die Ermittlung des hypothetischen Ableitstromwertes ist es möglich, den tatsächlich gegen Erde fließenden Ableitstrom in Abhängigkeit des Leitfähigkeitswertes und des Geräteparameters exakt zu bestimmen und erst im Falle einer Überschreitung des vorgegebenen Ableitstromschwellwertes durch die Reduktion der Heizleistung der Blankdrahtheizeinrichtung den tatsächlich gegen Erde fließenden Ableitstrom zu reduzieren. Die Reduktion der Heizleistung kann dabei auf vielfältige Weise erfolgen, beispielsweise durch vollständiges oder teilweises Abschalten der Heizeinrichtung, Reduzieren der an die Heizeinrichtung angelegten Betriebsspannung, Leistungsreduktion durch Halbwellen und-/oder Phasenanschnittsteuerung. Der bauartbedingte Geräteparameter umfasst beispielsweise eine gerätespezifische Konstante, die einen Zusammenhang zwischen dem Leitfähigkeitswert und dem zu erwartenden Ableitstrom darstellt. Der bauartbedingte Geräteparameter hängt beispielsweise von dem Kanalquerschnitt der Kanalanordnung, der Länge des elektrisch nicht-leitenden Kanals, von der Geometrie und dem Einbauort der Blankdrahtheizeinrichtung sowie der Anzahl der Blankdrahtheiteinrichtungen ab. Durch Vorgabe des Geräteparameters für einen jeden Blankdrahtdurchlauferhitzertyp kann aus dem Leitfähigkeitswert der hypothetische Ableitstromwert ermittelt werden, ohne dass es der Messung des tatsächlichen fließenden Ableitstromes bedarf.

Gemäß einer weiter bevorzugten Ausbildung der Erfindung wird eine Wassertemperatur des durch die Kanalanordnung fließenden Wassers gemessen und der hypothetische Ableitstromwertes bei einer vorgegebenen Bezugstemperatur ferner auf Basis der gemessenen Wassertemperatur ermittelt. Dies bietet den Vorteil, dass der Einfluss der Wassertemperatur bei der Bestimmung des hypothetischen Ableitstromwertes Berücksichtigung findet und so ein vorgegebener Ableitstromschwellwert bei einer definierten Bezugstemperatur präzise eingehalten werden kann. Üblicherweise wird gefordert, dass der tatsächliche Gesamtableitstrom bei einer vorgegebenen Bezugstemperatur des Wassers, beispielsweise bei 15°C, einen vorgegebenen Ableitstromschwellwert, beispielsweise in Höhe von typisch 5 mA nicht überschreitet. Grundsätzlich steigt der Leitwert von Wasser mit steigender Temperatur an, so dass beim Betrieb des Blankdrahtdurchlauferhitzers mit Wasser einer höhen Temperatur als der Bezugstemperatur ein höher hypothetischer Ableitstrom mittels der Auswerteeinrichtung ermittelt würde.

Eine weitere vorteilhafte Ausbildung der Erfindung ist gekennzeichnet durch Bestimmen des Leitfähigkeitswertes bei der vorgegebenen Bezugstemperatur aus einer gemessenen Leitfähigkeit des Wassers und der gemessenen Wassertemperatur. Dies bietet den Vorteil, dass bereits die gemessen Leitfähigkeit des Wassers auf die Bezugstemperatur normiert wird und so ein entsprechender auf die Bezugstemperatur angepasster Leitfähigkeitswert ermittelt wird. Beträgt die Wassertemperatur beispielsweise 30°C, während die Bezugstemperatur 15°C beträgt, so ist die gemessene Leitfähigkeit des Wassers aufgrund der mit der Temperatur ansteigenden Leitfähigkeit des Wassers größer, als die Leitfähigkeit, die das Wasser bei einer Bezugstemperatur von 15°C aufweisen würde.

Eine weitere vorteilhafte Ausbildung der Erfindung zeichnet sich dadurch aus, dass die Wassertemperatur in einem Wasserzulaufbereich gemessen wird. So wird vorteilhafter Weise die Temperatur des zu erwärmenden Wasser beim Einlauf in den Blankdrahtdurchlauferhitzer gemessen. Dies ist insbesondere dann vorteilhaft, wenn der Blankdrahtdurchlauferhitzer zur Nacherwärmung von bereits vorgewärmtem Brauchwasser zum Einsatz kommt. Der Wasserzulaufbereich umfasst sowohl den Wasserzulaufkanal als auch einen Teilbereich des Wasser führenden nicht-leitfähigen Kanals, nämlich den Bereich der Kanalanordnung, der sich bezüglich der Fließrichtung des Wassers vor der ersten Blankdrahtheizeinrichtung befindet.

Gemäß einer bevorzugten Weiterbildung der Erfindung wird eine Wasserauslauftemperatur in einem Wasserablaufbereich gemessen und der hypothetische Ableitstromwert bei einer vorgegebenen Bezugstemperatur ferner auf Basis der gemessenen Wasserauslauftemperatur ermittelt. Auf diese Weise wird der hypothetische Ableitstrom mit hoher Präzision ermittelt. Die Wassertemperatur des durch die Blankdrahtheizeinrichtung bzw. durch die Blankdrahtheizeinrichtungen erwärmten Wassers, d.h. die Wasserauslauftemperatur wird gemessen und ausgehend von dieser ein hypothetischer erster Teilableitstrom, der zwischen der Blankdrahtheizeinrichtung und dem Wasserablaufkanal gegen Erde fließt, ermittelt. Andererseits wird ein hypothetischer zweiter Teilableitstrom, der zwischen der Blankdrahtheizeinrichtung und dem Wasserzulaufkanal gegen Erde fließt, auf Basis der Wassereinlauftemperatur zu ermitteln. Vorzugsweise wird dann der hypothetische Ableitstrom, d.h. der hypothetische Gesamtableitstrom, der sich aus der Summe der ersten und zweiten Teilableitströme ergibt, ermittelt. Der Wasserablaufbereich umfasst sowohl den Wasserablaufkanal als auch einen Teilbereich des Wassers führenden nicht-leitfähigen Kanals, also den Bereich der Kanalanordnung, der sich bezüglich der Fließrichtung des Wassers nach der letzten Blankdrahtheizeinrichtung befindet.

Weitere bevorzugte und/oder zweckmäßige Merkmale und Ausgestaltungen der Erfindung ergeben sich aus den Unteransprüchen und der Beschreibung. Besonders bevorzugte Ausführungsformen werden anhand der beigefügten Zeichnung näher erläutert. In der Zeichnung zeigt

Fig. 1 bis Fig. 6 jeweils schematische Darstellungen des erfindungsgemäßen elektrischen Blankdrahtdurchlauferhitzers mit unterschiedlichen Elektrodenkonfigurationen der Leitfähigkeitsmesseinrichtung,

Fig. 7 ein Schaltbild der Leitfähigkeitsmesseinrichtung·gemäß eine beispielhaften Ausführungsform und

Fig. 8 eine weitere vorteilhafte Ausbildung der in Fig. 7 gezeigten Leitfähigkeitsmesseinrichtung.

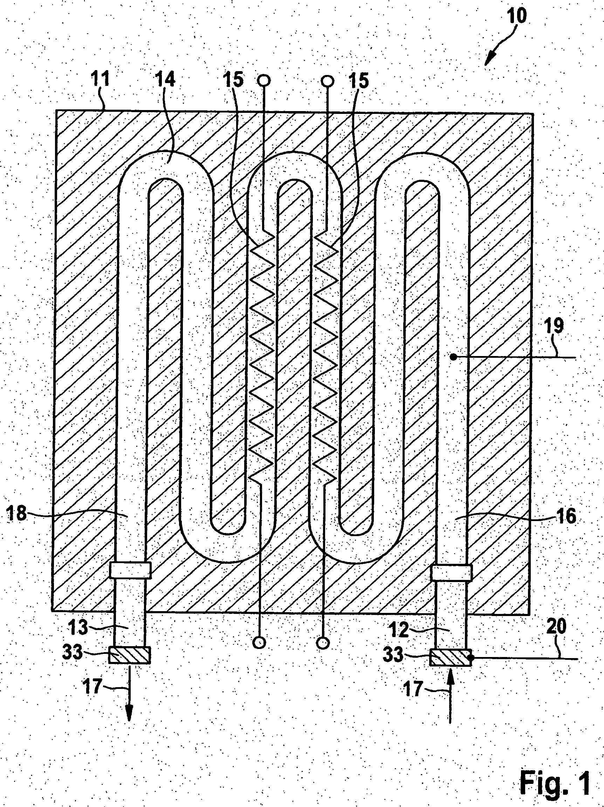

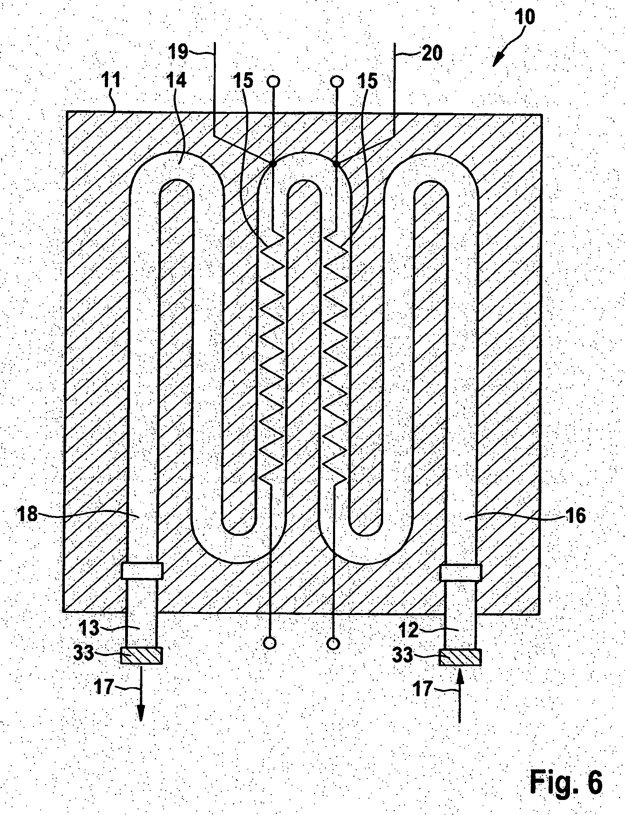

In den Figuren 1 bis 6 ist jeweils der erfindungsgemäße Blankdrahtdurchlauferhitzer 10 schematisch gezeigt. Der Blankdrahtdurchlauferhitzer 10 umfasst eine Kanalanordnung 11. Die Kanalanordnung 11 umfasst einen Wasserzulaufkanal 12 sowie einen Wasserablaufkanal 13. Der Wasserzulaufkanal 12 ist zum Anschluss an eine erste äußere - in der Zeichnung nicht gezeigte - Wasser zuführende Wasserleitung eingerichtet, während der Wasserablaufkanal 13 zum Anschluss an eine zweite äußere - ebenfalls in der Zeichnung nicht gezeigte - Wasser abführenden Wasserleitung eingerichtet. Anders ausgedrückt dient der Wasserzulaufkanal 12 dem Zufluss von zu erwärmendem Wasser, während aus dem Wasserablaufkanal 13 das im Blankdrahtdurchlauferhitzer 10 erwärmte Wasser entnommen bzw. abgeführt wird. Der Wasser zulaufkanal 12 und der Wasserablaufkanal 13 sind elektrisch leitend ausgebildet, beispielsweise aus einem leitfähigen Metall, und jeweils mit dem Erdpotential, d.h. mit dem Schutzleiter, elektrisch leitend verbunden (in der Zeichnung nicht gezeigt). Der Wasserzulaufkanal 12 und der Wasserablaufkanal 13 umfassen bevorzugt jeweils ein Wasserleitungsanschlussstück 33 und einen Zulauf- bzw. einen Ablaufkanal. Mit anderen Worten wird der Wasserzulaufkanal 12 durch eines der Wasseranschlussstücke 33 und dem Zulaufkanal gebildet, während der Wasserablaufkanal 13 aus einem der Wasserleitungsanschlussstücke 33 und dem Ablaufkanal gebildet wird. Besonders bevorzugt sind jeweils die Wasseranschlussstücke 33 aus einem elektrisch leitfähigen Material, beispielsweise aus Messing gebildet, während der Zulauf- und der Ablaufkanal aus einem elektrisch nicht-leitfähigen Material sind. Alternativ sind der Zulauf- und der Ablaufkanal ebenfalls aus einem elektrisch leitfähigen Material gebildet.

Der Wasserzulaufkanal 12 und der Wasserablaufkanal 13 bilden die Kanalenden mindestens eines Wasser führenden Kanals 14. Der Kanal 14 ist elektrisch nichtleitfähig ausgebildet, beispielsweise aus einem nicht-leitenden Kunststoff oder dergleichen. Zum Erwärmen des durch die Kanalanordnung 11 fließenden Wassers ist in dem elektrisch nicht-leitfähigen Kanal 14 eine elektrische Blankdrahtheizeinrichtung 15 angeordnet. Die Anzahl der Blankdrahtheizeinrichtungen 15 ist nicht auf eine beschränkt. Vielmehr sind, wie in den Figuren 1 bis 6, gezeigt bevorzugt zwei Blankdrahtheizeinrichtungen 15 in dem Kanal 14 angeordnet. Alternativ sind mehr als zwei Blankdrahtheizeinrichtungen 15 in dem Kanal 14 angeordnet. Im Folgenden wird zur Vereinfachung von der Blankdrahtheizeinrichtung 15 stets nur im Singular gesprochen.

Der erfindungsgemäße Blankdrahtdurchlauferhitzer umfasst eine zum Regeln der Heizleistung der Blankdrahtheizeinrichtung 15 eingerichtete, in der Zeichnung nicht gezeigte, elektronische Steuereinrichtung. Die Steuereinrichtung umfasst vorzugsweise Schalt- und/oder Steuermittel, mit denen die der Blankdrahtheizeinrichtung 15 zugeführte elektrische Leistung, in Stufen oder stufenlos einstellbar ist, beispielsweise durch entsprechende Leistungsendstufen mittels Leistungsschaltern wie Thyristoren, Triacs, Halbleiterrelais, Relais und dergleichen. Zur stufenlosen Einstellung der Heizleistung weist die Steuereinrichtung bevorzugt Leistungsschalter zur Halbwellensteuerung und/oder Phasenanschnittsteuerung auf.

Weiter umfasst die Steuereinrichtung eine Leitfähigkeitsmesseinrichtung. Die Leitfähigkeitsmesseinrichtung ist zur Bestimmung eines Leitfähigkeitswertes des durch die Kanalanordnung 11 fließenden Wassers ausgebildet und eingerichtet.

Weiter umfasst die Steuereinrichtung eine Auswerteeinheit, die zum Ermitteln eines hypothetischen Ableitstromwertes auf Basis des Leitfähigkeitswertes und mindestens einem, vorgegebenen bauartbedingten Geräteparameter ausgebildet und eingerichtet ist. Der hypothetische Ableitstromwert entspricht dabei dem zu erwartenden Gesamtableitstrom, der aufgrund der mit Betriebsspannung versorgten Blankdrahtheizeinrichtung 15 über den durch das Wasser in dem Kanal 14 gebildeten jeweiligen Isolationswiderständen, die jeweils von der Leitfähigkeit des Wasser abhängen, über den Wasserzulaufkanal 12 und den Wasserablaufkanal 13 gegen Erde fließen. Wie eingangs beschrieben, hängt der hypothetische Ableitstromwert wesentlich vom dem bauartbedingten Geräteparameter ab, der - wie eingangs beschrieben - eine Vielzahl von relevanten Größen zur Ermittlung des hypothetischen Ableitstromwertes berücksichtigt.

Die Steuereinrichtung ist angepasst, die Heizleistung der Blankdrahtheizeinrichtung 15 zu reduzieren, sofern der hypothetische Ableitstromwert einen vorgegebenen Ableitstromschwellwert übersteigt. Anders ausgedrückt ist die Steuereinrichtung dazu eingerichtet, die Heizleistung der Blankdrahtheizeinrichtung 15 zu verringern bzw. die Blankdrahtheizeinrichtung 15 vollständig auszuschalten, falls der zu erwartende Ableitstromwert den vorgegebenen Ableitstromschwellwert übersteigt. Besonders bevorzugt ist der vorgegebene Ableitstromschwellwert fest eingestellt und kann seitens des Nutzers nicht verändert werden, um den jeweiligen gesetzlichen Anforderungen hinsichtlich des maximal zulässigen tatsächlich fließenden Ableitstromes einzuhalten.

Vorzugsweise weist die Steuereinrichtung mindestens einen ersten - in der Zeichnung nicht gezeigten - Temperaturfühler auf. Der Temperaturfühler ist zum Messen einer Wassertemperatur des durch die Kanalanordnung 11 fließenden Wassers eingerichtet. Die Auswerteeinheit ist ferner eingerichtet, den hypothetischen Ableitstromwert bei einer vorgegebenen Bezugstemperatur auf Basis der mittels des Temperaturfühlers gemessenen Wassertemperatur zu ermitteln.

Besonders bevorzugt ist die Auswerteeinheit angepasst, den Leitfähigkeitswert bei der vorgegebenen Bezugstemperatur auf Basis der mittels der Leitfähigkeitsmesseinrichtung gemessenen Leitfähigkeit des Wasser und der Wassertemperatur zu bestimmen. Für die Leitfähigkeit $k_{T_0}$ des Wassers bei der Bezugstemperatur $T_0$ gilt die Beziehung

$$\kappa_{T_0}(\kappa_T, T) = \frac{1}{1 + m \cdot (T - T_0)} \cdot \kappa_T \quad ,$$

wobei $k_T$ die Leitfähigkeit des Wassers bei der Temperatur T und m den Temperaturkoeffizienten bezeichnet. Die Auswerteeinheit ist vorzugsweise eingerichtet, nach obiger Beziehung die Leitfähigkeit des Wassers bei der Bezugsbzw. Referenztemperatur zu ermitteln. Die Auswerteeinheit ist ferner eingerichtet, den hypothetischen Ableitstromwert bei der vorgegebenen Bezugstemperatur auf Basis des ermittelten Leitfähigkeitswertes bei der Bezugstemperatur zu ermitteln.

Weiter bevorzugt ist der erste Temperaturfühler in einem Wasserzulaufbereich 16 angeordnet und zum Messen einer Wassereinlauftemperatur eingerichtet und ausgebildet. Mit anderen Worten ist der erste Temperaturfühler in einem Bereich der Kanalanordnung 11 angeordnet, der sich in Fließrichtung 17 des Wassers vor der Blankdrahtheizeinrichtung 15 befindet.

Vorzugsweise umfasst die Steuereinrichtung mindestens einen zweiten Temperaturfühler. Der zweite Temperaturfühler ist in einem Wasserablaufbereich 18 angeordnet und zum Messen einer Wasserauslauftemperatur, d.h. der Temperatur des durch die Blankdrahtheizeinrichtung 15 erwärmten Wassers, angeordnet. Anders ausgedrückt ist der zweite Temperaturfühler in einem Bereich der Kanalanordnung 11 angeordnet, der sich in Fließrichtung 17 des Wassers nach der Blankdrahtheizeinrichtung 15 befindet.

Die Auswerteeinheit ist ferner eingerichtet, den hypothetischen Ableitstromwert bei der vorgegebenen Bezugstemperatur auf Basis der mittels des zweiten Temperaturfühlers gemessenen Wasserauslauftemperatur zu ermitteln. Die Auswerteeinheit ist daher einerseits eingerichtet, ausgehend von der mittels des ersten Temperaturfühlers gemessenen Wassereinlauftemperatur, einen hypothetischen ersten Teilableitstrom, der zwischen der Blankdrahtheizeinrichtung 15 und dem Wasserzulaufkanal 12 gegen Erde fließt, zu ermitteln. Andererseits ist die Auswerteeinheit dazu ausgebildet, einen hypothetischen zweiten Teilableitstrom, der zwischen der Blankdrahtheizeinrichtung 15 und dem Wasserablaufkanal 13 gegen Erde fließt, auf Basis der Wasserablauftemperatur zu ermitteln. Die Auswerteeinheit ist ferner dazu eingerichtet, den hypothetischen Ableitstrom, d.h. den hypothetischen Gesamtableitstrom, der sich aus der Summe, besonders bevorzugt aus der vektoriellen Summe, der ersten und zweiten Teilableitströme ergibt, zu ermitteln.

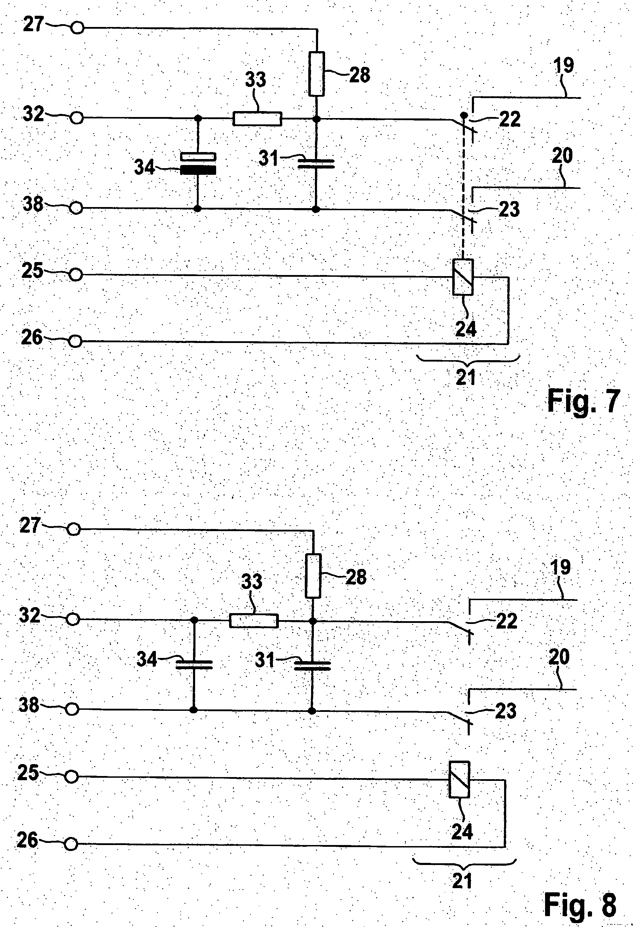

Bevorzugt umfasst die Leitfähigkeitsmesseinrichtung zwei Elektroden, nämlich eine erste Elektrode 19 und eine zweite Elektrode 20. Die Elektroden 19, 20 stehen jeweils mit dem durch die Kanalanordnung 11 fließenden Wasser in Kontakt. Die Elektroden 19, 20 sind darüber hinaus elektrisch mit der Auswerteeinheit verbunden. Eine beispielhafte Anschaltung der Elektroden 19, 20 wird weiter unten im Zusammenhang mit der Fig. 7 erläutert.

Für die Anordnung der Elektroden 19, 20 sind eine Vielzahl von unterschiedlichen Varianten vorgesehen. Vorzugsweise ist eine der Elektroden 19, 20 in Fließrichtung 17 des Wassers vor der Blankdrahtheizeinrichtung 15 angeordnet, während die jeweils andere der Elektroden 20, 19 in Fließrichtung 17 nach der der Blankdrahtheizeinrichtung 15 angeordnet ist (in der Zeichnung nicht gezeigt).

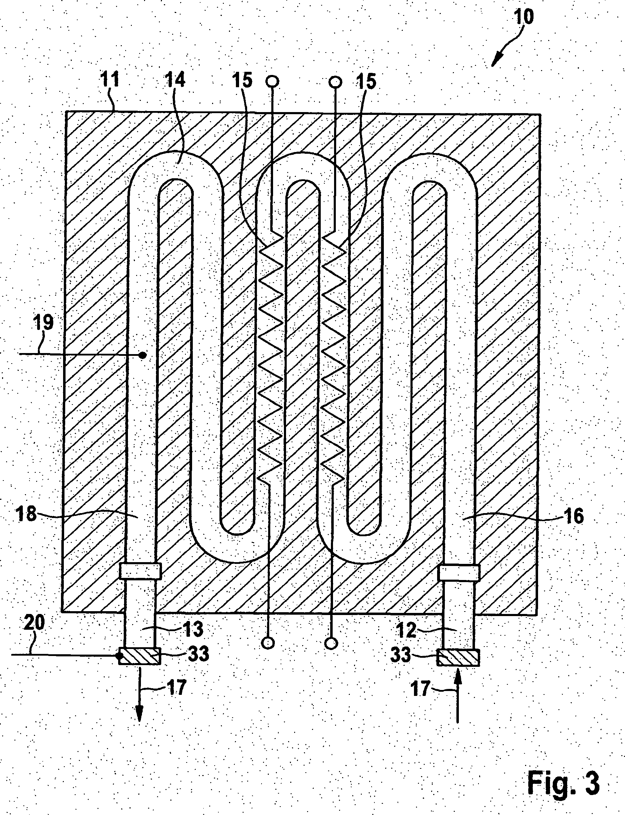

Weiter bevorzugt ist zumindest eine der Elektroden 20 durch den Wasserzulaufkanal 12, wie in Fig. 1 gezeigt, und zumindest eine der Elektroden 19 durch den Wasserablaufkanal 13, wie in Fig. 3 gezeigt, gebildet.

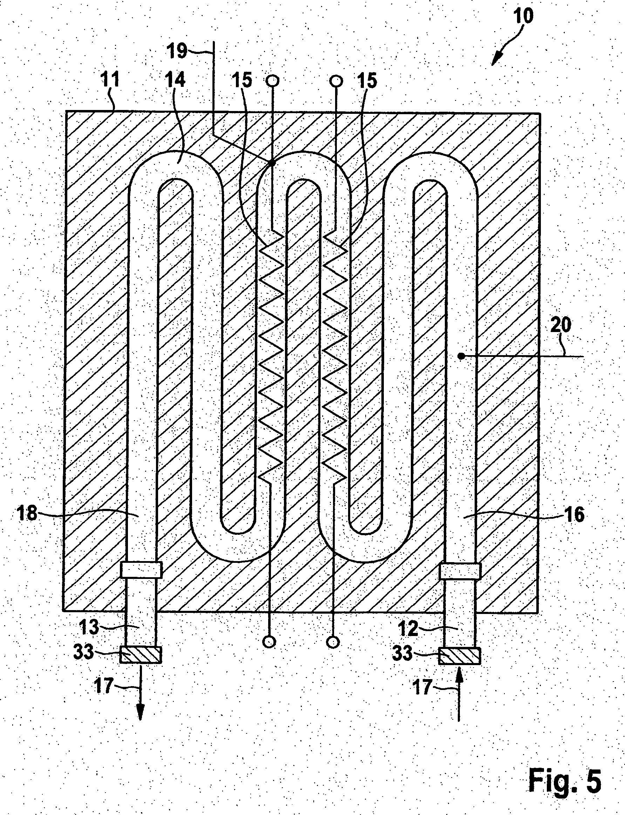

Gemäß einer weiteren vorteilhaften Ausbildung ist zumindest eine der Elektroden 19 durch die Blankdrahtheizeinrichtung 15 gebildet, wie in Fig. 5 gezeigt. Alternativ werden die Elektroden 19, 20 jeweils durch die Blankdrahtheizeinrichtungen 15 gebildet.

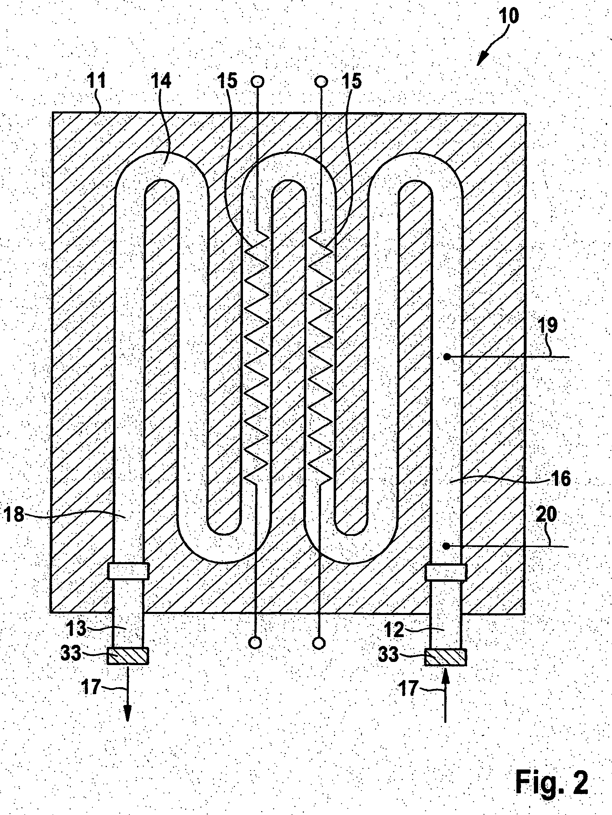

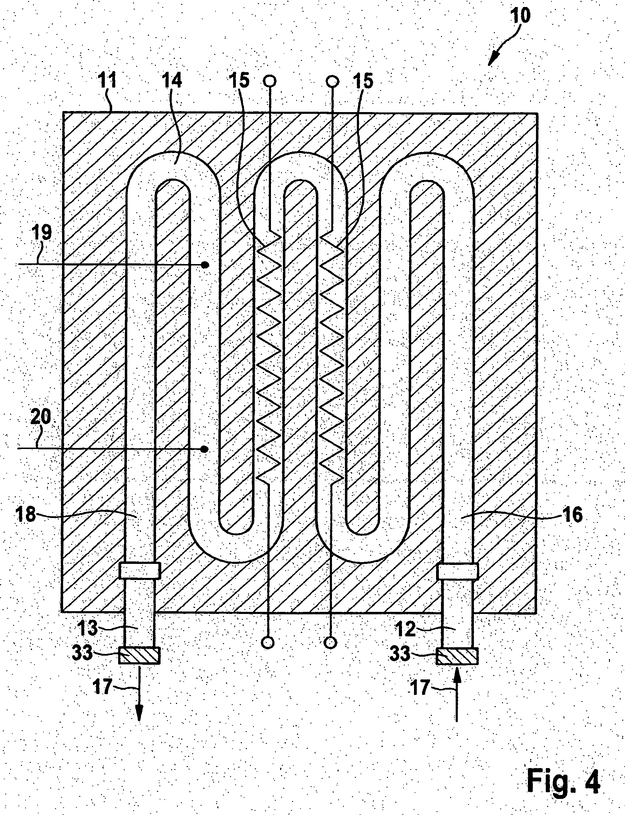

Neben den zuvor beschriebenen Elektrodenkonfigurationen sind eine Vielzahl von weiteren Konfigurationen Gegenstand der vorliegenden Erfindung, von denen auf einige ausgewählte im Folgenden detailliert eingegangen wird. Fig. 1 zeigt eine der Elektroden 19 als separate Elektrode 19 im Wasserzulaufbereich 16, während die Elektrode 20 durch den Wasserzulaufkanal 12 gebildet wird. Gemäß einer weiteren in Fig. 2 gezeigten Ausführungsform sind beide Elektroden 19, 20 als separate Elektroden 19, 20 ausgebildet, die im Wasserzulaufbereich 16 angeordnet sind. Eine alternative Ausführungsform gemäß Fig. 3 zeigt eine der Elektroden 19 als separate Elektrode 19 im Wasserablaufbereich 18, während die andere der Elektroden 20 durch den Wasserablaufkanal 13 gebildet ist. Gemäß einer weiteren, in der Fig. 4 gezeigten, Ausbildung der Erfindung sind beide der Elektroden 19, 20 im Wasserablaufbereich 18 angeordnet. Eine weitere Variante der vorliegenden Erfindung zeigt Fig. 5, bei der eine der Elektroden 19 durch eine der Blankdrahtheizungseinrichtungen 15 gebildet ist, während die andere Elektrode 20 als separate Elektrode 20 in dem Wasserzulaufbereich 16 angeordnet ist. Die vorliegende Erfindung ist nicht auf die vorgenannten Elektrodenkonfigurationen beschränkt. Vielmehr sind auch Unterkombinationen der vorgenannten Konfiguration von der Erfindung erfasst.

Vorzugsweise sind die Elektroden 19, 20 der Leitfähigkeitsmesseinrichtung über ein Trennmittel 21 spannungsfrei schaltbar ausgebildet und eingerichtet. Mittels des Trennmittels 21 wird die zur Messung der Leitfähigkeit an die Elektroden 19, 20 anzulegende Spannung nur während der Messung angelegt. Während der Messpausen liegt an den Elektroden 19, 20 keine Spannung an, so dass elektrolytische Prozesse an den Elektroden19, 20 zuverlässig vermieden werden.

Fig. 7 zeigt eine beispielhafte Beschaltung der Elektroden 19, 20. Die Elektroden sind über das Trennmittel 21, beispielsweise in Form eines Relais, spannungsfrei schaltbar ausgebildet. Hierzu sind die Elektroden 19, 20 jeweils über die Relaiskontakte 22,23 mit den weiteren Bauelementen verbunden. Die Relaisspule 24 ist über die Anschlüsse 25, 26 mit der Auswerteinheit bzw. der Steuereinrichtung elektrisch verbunden. Die Steuereinrichtung bzw die Auswerteeinheit sind entsprechend zum Spannungfreibzw. anschalten der Elektroden 19, 20 eingerichtet. Über den Anschluss 27 der Steuereinrichtung bzw. der Auswerteeinheit wird eine Gleichspannung, beispielsweise mit einer Spannung von 5V bereitgestellt. Die Elektroden 19 und 20 bilden zusammen mit dem Widerstand 28 einen zwischen dem Anschluss 27 und dem Anschluss 38 der Steuereinrichtung bzw. der Auswerteeinheit einen Spannungsteiler, dessen Spannung am Knotenpunkt 30 von der Leitfähigkeit des die Elektroden 19, 20 umfließenden Wassers abhängt. Vorzugsweise ist parallel zu den Elektroden 19, 20 ein Kondensator 31 geschaltet, der zum Ablocken von Störeinflüsse, beispielsweise von hochfrequenten Störsignalen, ausgebildet ist. Weiter bevorzugt ist zwischen dem Knotenpunkt 30 und dem Eingang 32 der Steuereinrichtung bzw. der Auswerteeinheit ein Tiefpassfilter geschaltet, das aus dem Widerstand 33 und dem Kondensator 34 gebildet ist. Das Tiefpassfilter ist vorzugsweise als Antialiasingfilter ausgebildet, und einem - in der Zeichnung nicht gezeigten - Analog-/Digitalwandler der Steuereinrichtung bzw. der Auswerteeinheit vorgeschaltet. Besonders bevorzugt ist der Kondensator 31 als bipolarer Kondensator ausgebildet, beispielsweise als Folien- bzw. Keramikkondensator oder dergleichen, während der Kondensator 34 als Elektrolytkondensator ausgebildet ist.

Fig. 8 zeigt eine beispielhafte Beschaltung der Elektroden 19, 20 gemäß einer weiteren vorteilhaften Ausführung der Leitfähigkeitsmesseinrichtung. Die Ausführung entspricht im Wesentlichen der in der Fig. 7 gezeigten Ausführungsform, so dass auf die oben gemachten Ausführungen hierzu vollumfänglich Bezug genommen wird. Die in der Fig. 8 gezeigte Beschaltung unterscheidet sich von der in der Fig. 7 darin, dass die Kondensatoren 31, 34 baugleich ausgeführt sind. Vorzugsweise sind beide Kondensatoren als bipolare Kondensatoren ausgebildet, beispielsweise als Folien- bzw. Keramikkondensatoren oder dergleichen.

Zur Vermeidung von Wiederholungen wird bezüglich des erfindungsgemäßen Verfahrens auf die zuvor gemachten Ausführungen hinsichtlich der Funktionsweise der Steuereinrichtung, der Auswerteeinheit und der Leitfähigkeitsmesseinrichtung und des Trennmittels verwiesen, die jeweils auch für die entsprechenden Verfahrensschritte relevant sind.

**Patentansprüche**

1. Elektrischer Blankdrahtdurchlauferhitzer (10) zur Warmwasserbereitung, umfassend
eine Kanalanordnung (11) mit einem elektrisch leitfähigen und mit dem Erdpotential elektrisch leitend verbundenen Wasserzulaufkanal (12), der zum Anschluss an eine erste äußere, Wasser zuführende Wasserleitung eingerichtet ist und
einem elektrisch leitfähigen und mit dem Erdpotential elektrisch leitend verbundenen Wasserablaufkanal (13), der zum Anschluss an eine zweite äußere, Wasser abführende Wasserleitung eingerichtet ist,
wobei die Kanalanordnung (11) mindestens einen Wasser führenden elektrisch nicht-leitfähigen Kanal (14) umfasst, an dessen Kanalenden jeweils der Wasserzulaufkanal (12) und der Wasserablaufkanal (13) angeordnet sind,
eine zum Erwärmen von durch die Kanalanordnung (11) fließendem Wasser eingerichtete elektrische Blankdrahtheizeinrichtung (15),
eine zum Regeln der Heizleistung der Blankdrahtheizeinrichtung (15) eingerichtete elektronische Steuereinrichtung, wobei die Steuereinrichtung eine Leitfähigkeitsmesseinrichtung zur Bestimmung eines Leitfähigkeitswertes des durch die Kanalanordnung (11) fließenden Wassers umfasst,
**dadurch gekennzeichnet, dass**
die Steuereinrichtung eine zum Ermitteln eines hypothetischen Ableitstromwertes auf Basis des Leitfähigkeitswertes und mindestens einem, vorgegebenen, bauartbedingten Geräteparameter eingerichtete Auswerteeinheit umfasst und
die Steuereinrichtung angepasst ist, die Heizleistung der Blankdrahtheizeinrichtung (15) zu reduzieren, sofern der hypothetische Ableitstromwert einen vorgegebenen Ableitstromschwellwert übersteigt.

2. Blankdrahtdurchlauferhitzer (10) nach Anspruch 1, **dadurch gekennzeichnet, dass** die Steuereinrichtung mindestens einen ersten Temperaturfühler zum Messen einer Wassertemperatur des durch die Kanalanordnung (11) fließenden Wassers umfasst und die Auswerteeinheit eingerichtet ist, den hypothetischen Ableitstromwert bei einer vorgegebenen Bezugstemperatur ferner auf Basis der mittels des Temperaturfühlers gemessenen Wassertemperatur zu ermitteln.

3. Blankdrahtdurchlauferhitzer (10) nach Anspruch 2, **dadurch gekennzeichnet, dass** die Auswerteeinheit angepasst ist, den Leitfähigkeitswert bei der vorgegebenen Bezugstemperatur aus der mittels der Leitfähigkeitsmesseinrichtung gemessenen Leitfähigkeit des Wassers und der Wassertemperatur zu bestimmen.

4. Blankdrahtdurchlauferhitzer (10) nach einem der Ansprüche 2 oder 3, **dadurch gekennzeichnet, dass** der erste Temperaturfühler in einem Wasserzulaufbereich zum Messen einer Wassereinlauftemperatur angeordnet ist.

5. Blankdrahtdurchlauferhitzer (10) nach einem der Ansprüche 2 bis 4, **dadurch gekennzeichnet, dass** die Steuereinrichtung mindestens einen zweiten in einem Wasserablaufbereich angeordneten Temperaturfühler zum Messen einer Wasserauslauftemperatur umfasst und die Auswerteeinheit eingerichtet ist, den hypothetischen Ableitstromwert bei der vorgegebenen Bezugstemperatur ferner auf Basis der mittels des zweiten Temperaturfühlers gemessenen Wasserauslauftemperatur zu ermitteln.

6. Blankdrahtdurchlauferhitzer (10) nach einem der Ansprüche 1 bis 5, **dadurch gekennzeichnet, dass** die Leitfähigkeitsmesseinrichtung zwei Elektroden (19, 20) umfasst, die jeweils mit dem durch die Kanalanordnung (11) fließendem Wasser in Kontakt stehen.

7. Blankdrahtdurchlauferhitzer (10) nach Anspruch 6, **dadurch gekennzeichnet, dass** eine der Elektroden (19, 20) in Fließrichtung des Wassers vor der Blankdrahtheizeinrichtung (15) und die jeweils andere der Elektroden (20, 19) in Fließrichtung des Wasser nach der Blankdrahtheizeinrichtung (15) angeordnet ist.

8. Blankdrahtdurchlauferhitzer (10) nach einem der Ansprüche 6 oder 7, **dadurch gekennzeichnet, dass** zumindest eine der Elektroden (19, 20) durch den Wasserzulaufkanal (12) oder durch den Wasserablaufkanal (20) gebildet ist.

9. Blankdrahtdurchlauferhitzer (10) nach einem der Ansprüche 6 oder 8, **dadurch gekennzeichnet, dass** zumindest eine der Elektroden (19, 20) durch die Blankdrahtheizeinrichtung (15) gebildet ist.

10. Blankdrahtdurchlauferhitzer (10) nach einem der Ansprüche 6 bis 9, **dadurch gekennzeichnet, dass** die Elektroden (19, 20) der Leitfähigkeitsmesseinrichtung über mindestens ein Trennmittel (21) spannungsfrei schaltbar sind.

11. Verfahren zum Steuern eines elektrischen Blankdrahtdurchlauferhitzers (10) mit folgendem Schritt :

Bestimmen eines Leitfähigkeitswertes von durch eine Kanalanordnung (11) des Blankdrahtdurchlauferhitzers (10) fließenden Wassers,

**gekennzeichnet durch**
Ermitteln eines hypothetischen Ableitstromwertes auf Basis des Leitfähigkeitswertes und mindestens einem vorgegebenen, bauartbedingten Geräteparameter,
Vergleichen des hypothetischen Ableitstromwertes mit einem vorgegebenen Ableitstromschwellwert und sofern der hypothetische Ableitstromwert den vorgegebenen Ableitstromschwellwert übersteigt, Reduzieren der Heizleistung einer Blankdrahtheizeinrichtung (15) des Blankdrahtdurchlauferhitzers (10).

12. Verfahren nach Anspruch 11, **gekennzeichnet durch** Messen einer Wassertemperatur des **durch** die Kanalanordnung (11) fließenden Wassers und Ermitteln des hypothetischen Ableitstromwertes bei einer vorgegebenen Bezugstemperatur ferner auf Basis der gemessenen Wassertemperatur.

13. Verfahren nach Anspruch 12, **gekennzeichnet durch** Bestimmen des Leitfähigkeitswertes bei der vorgegebenen Bezugstemperatur aus einer gemessenen Leitfähigkeit des Wassers und der gemessenen Wassertemperatur.

14. Verfahren nach einem der Ansprüche 12 oder 13, **dadurch gekennzeichnet, dass** die Wassertemperatur in einem Wasserzulaufbereich (16) gemessen wird.

15. Verfahren nach einem der Ansprüche 12 bis 14, **gekennzeichnet durch** Messen einer Wasserauslauftemperatur in einem Wasserablaufbereich (18) und Ermitteln des hypothetischen Ableitstromwertes bei einer vorgegebenen Bezugstemperatur ferner auf Basis der gemessenen Wasserauslauftemperatur.

**Claims**

1. Electric bare wire continuous-flow heater (10) for water heating, comprising
a channel arrangement (11) having a water inlet channel (12), which is electrically conductive and connected electroconductively to the earth potential, said inlet channel being set up for connection to a first external water pipe supplying water and
a water outlet channel (13), which is electrically conductive and connected electroconductively to the earth potential, said outlet channel being set up for connection to a second external water pipe discharging water,
wherein the channel arrangement (11) comprises at least one water-carrying, electrically non-conductive channel (14) at each end of which the water inlet channel (12) and the water outlet channel (13) respectively are arranged,
an electrical bare wire heating device (15) for heating water flowing through the channel arrangement (11),
an electronic control device set up to control the heating output of the bare wire heating device (15),
wherein the control device comprises a conductivity measuring device for determining a conductivity value of the water flowing through the channel arrangement (11),
**characterised in that**
the control device comprises an evaluation unit set up to identify a hypothetical leakage current value based on the conductivity value and at least one, specified, design-inherent device parameter and
the control device is adjusted to reduce the heating output of the bare wire heating device (15) if the hypothetical leakage current value exceeds a specified leakage current threshold value.

2. Bare wire continuous-flow heater (10) according to claim 1, **characterised in that** the control device comprises at least one first temperature sensor for measuring a water temperature of the water flowing through the channel arrangement (11) and the evaluation unit is set up to identify the hypothetical leakage current value at a specified reference temperature further based on the water temperature measured by means of the temperature sensor.

3. Bare wire continuous-flow heater (10) according to claim 2, **characterised in that** the evaluation unit is adjusted to determine the conductivity value at the specified reference temperature from the conductivity of the water measured by means of the conductivity measuring device and the water temperature.

4. Bare wire continuous-flow heater (10) according to any one of claims 2 or 3, **characterised in that** the first temperature sensor is arranged in a water inlet region for measuring a water inlet temperature.

5. Bare wire continuous-flow heater (10) according to any one of claims 2 to 4, **characterised in that** the control device comprises at least one second temperature sensor, arranged in a water outlet region, for measuring a water outlet temperature and the evaluation unit is set up to identify the hypothetical leakage current value at the specified reference temperature further based on the water outlet temperature measured by means of the second temperature sensor.

6. Bare wire continuous-flow heater (10) according to any one of claims 1 to 5, **characterised in that** the conductivity measuring device comprises two electrodes (19, 20) each of which is in contact with the water flowing through the channel arrangement (11).

7. Bare wire continuous-flow heater (10) according to claim 6, **characterised in that** one of the electrodes (19, 20) is arranged in the flow direction of the water upstream of the bare wire heating device (15) and the other electrode (20, 19) in each case is arranged in the flow direction of the water downstream of the bare wire heating device (15).

8. Bare wire continuous-flow heater (10) according to any one of claims 6 or 7, **characterised in that** at least one of the electrodes (19, 20) is formed by the water inlet channel (12) or by the water outlet channel (20).

9. Bare wire continuous-flow heater (10) according to any one of claims 6 or 8, **characterised in that** at least one of the electrodes (19, 20) is formed by the bare wire heating device (15).

10. Bare wire continuous-flow heater (10) according to any one of claims 6 to 9, **characterised in that** the electrodes (19, 20) of the conductivity measuring device can be de-energised by way of at least one disconnecting means (21).

11. Method for controlling an electrical bare wire continuous-flow heater (10) having the following step:

 Determination of a conductivity value of water flowing through a channel arrangement (11) of said bare wire continuous-flow heater (10), **characterised by**
 Identification of a hypothetical leakage current value based on the conductivity value and at least one specified, design-inherent device parameter,
 Comparison of the hypothetical leakage current value with a specified leakage current threshold value and if the hypothetical leakage current value exceeds the specified leakage current threshold value, reduction of the heating output of a bare wire heating device (15) of the bare wire continuous-flow heater (10).

12. Method according to claim 11, **characterised by** measurement of a water temperature of the water flowing through the channel arrangement (11) and identification of the hypothetical leakage current value at a specified reference temperature further based on the measured water temperature.

13. Method according to claim 12, **characterised by** determination of the conductivity value at the specified reference temperature from a measured conductivity of the water and the measured water temperature.

14. Method according to any one of claims 12 or 13, **characterised in that** the water temperature is measured in a water inlet region (16).

15. Method according to any one of claims 12 to 14, **characterised by** measurement of a water outlet temperature in a water outlet region (18) and identification of the hypothetical leakage current value at a specified reference temperature further based on the measured water outlet temperature.

**Revendications**

1. Chauffe-eau électrique instantané à fil nu (10) pour la préparation d'eau chaude, comprenant
 un agencement de canaux (11) avec un canal d'amenée d'eau (12) électriquement conducteur et électriquement connecté à la terre qui est adapté pour un raccordement à un premier conducteur extérieur amenant de l'eau, et avec un canal de départ d'eau (13) électriquement conducteur et électriquement connecté à la terre qui est adapté pour un raccordement à un deuxième conducteur extérieur amenant de l'eau, l'agencement de canaux (11) comprenant au moins un canal (14) transportant de l'eau et n'étant pas électriquement conducteur, aux extrémités de canal duquel sont disposés respectivement le canal d'amenée d'eau (12) et le canal de départ d'eau (13),

un dispositif de chauffe électrique à fil nu (15) adapté pour chauffer de l'eau passant par l'agencement de canaux (11),

un dispositif de commande électronique adaptée pour la commande de la puissance de chauffe du dispositif de chauffe à fil nu (15),

le dispositif de commande comportant un dispositif de mesure de conductivité pour déterminer une valeur de conductivité de l'eau passant par l'agencement de canaux (11),

**caractérisé en ce que**

le dispositif de commande comprend une unité d'exploitation agencée pour déterminer une valeur hypothétique de courant de fuite sur la base d'une valeur de conductivité et d'au moins un paramètre d'appareil prédéterminé et fonction du type d'appareil, et

le dispositif de commande est adapté pour réduire la puissance de chauffe du dispositif de chauffe à fil nu (15) si la valeur hypothétique de courant de fuite dépasse une valeur de seuil prédéterminée de courant de fuite.

2.  Chauffe-eau électrique instantané à fil nu (10) selon la revendication 1, **caractérisé en ce que** le dispositif de commande comprend au moins un premier capteur de température pour mesurer une température d'eau de l'eau passant par l'agencement de canaux (11) et **en ce que** l'unité d'exploitation est agencée pour déterminer la valeur hypothétique de courant de fuite à la température de référence prédéterminée en outre sur la base de la température d'eau mesurée à l'aide du capteur de température.

3.  Chauffe-eau électrique instantané à fil nu (10) selon la revendication 2, **caractérisé en ce que** l'unité d'exploitation est adaptée pour déterminer la valeur de conductivité à la température de référence prédéterminée sur la base de la conductivité de l'eau mesurée à l'aide du dispositif de mesure de conductivité de l'eau et de la température d'eau.

4.  Chauffe-eau électrique instantané à fil nu (10) selon l'une des revendications 2 ou 3, **caractérisé en ce que** le premier capteur de température est disposé dans une zone d'amenée d'eau pour mesurer une température d'entrée d'eau.

5.  Chauffe-eau électrique instantané à fil nu (10) selon l'une des revendications 2 à 4, **caractérisé en ce que** l'unité d'exploitation comprend au moins un deuxième capteur de température disposé dans une zone de départ d'eau pour mesurer une température de départ d'eau et **en ce que** l'unité d'exploitation est agencée pour déterminer la valeur hypothétique de courant de fuite à la température de référence prédéterminée en outre sur la base de la température de départ d'eau mesurée à l'aide du deuxième capteur de température.

6.  Chauffe-eau électrique instantané à fil nu (10) selon l'une des revendications 1 à 5, **caractérisé en ce que** le dispositif de mesure de conductivité comprend deux électrodes (19, 20) qui sont en contact avec l'eau passant par l'agencement de canaux (11).

7.  Chauffe-eau électrique instantané à fil nu (10) selon la revendication 6, **caractérisé en ce que** l'une des électrodes (19, 20) est disposée, vu dans le sens du flux de l'eau, en amont du dispositif de chauffe à fil nu (15) et que la respectivement autre des électrodes (19, 20) est disposée, vu dans le sens du flux de l'eau, en aval du dispositif de chauffe à fil nu (15).

8.  Chauffe-eau électrique instantané à fil nu (10) selon l'une des revendications 6 ou 7, **caractérisé en ce qu'**au moins une des électrodes (19, 20) est constituée par le canal d'amenée d'eau (12) ou par le canal de départ d'eau (20).

9.  Chauffe-eau électrique instantané à fil nu (10) selon l'une des revendications 6 ou 8, **caractérisé en ce qu'**au moins une des électrodes (19, 20) est constituée par le dispositif de chauffe à fil nu (15).

10. Chauffe-eau électrique instantané à fil nu (10) selon l'une des revendications 6 à 9, **caractérisé en ce que** les électrodes (19, 20) du dispositif de mesure de conductivité sont aptes à être commutées hors tension à l'aide d'un moyen séparateur (21).

11. Procédé de commande d'un chauffe-eau électrique instantané à fil nu (10) avec l'étape suivante :

    déterminer une valeur de conductivité de l'eau passant par un agencement de canaux (11) du chauffe-eau électrique instantané à fil nu (10), **caractérisé par**
    déterminer une valeur hypothétique de courant de fuite sur la base de la valeur de conductivité et d'au moins un paramètre d'appareil prédéterminé et fonction du type d'appareil,
comparer la valeur hypothétique de courant de fuite avec une valeur prédéterminée de valeur de seuil de courant de fuite et, lorsque la valeur hypothétique de courant de fuite dépasse la valeur prédéterminée de valeur de seuil de courant de fuite, réduire la puissance de chauffe d'un dispositif de chauffe à fil nu (15) du chauffe-eau électrique instantané à fil nu (10).

12. Procédé selon la revendication 11, **caractérisé par** mesurer une température d'eau de l'eau passant par l'agencement de canaux (11) et déterminer la valeur hypothétique de courant de fuite à une température de référence prédéterminée en outre sur la base de la température d'eau mesurée.

13. Procédé selon la revendication 12, **caractérisé par** déterminer la valeur de conductivité à la température de référence prédéterminée sur la base d'une conductivité mesurée de l'eau et de la température d'eau mesurée.

14. Procédé selon l'une des revendications 12 ou 13, **caractérisé en ce que** la température d'eau est mesurée dans une zone d'amenée d'eau (16).

15. Procédé selon l'une des revendications 12 à 14, **caractérisé par** mesurer une température de départ d'eau dans une zone de départ d'eau (18) et déterminer la valeur hypothétique de courant de fuite à une température de référence prédéterminée en outre sur la base de la température de départ d'eau mesurée.

Fig. 1

**Fig. 2**

Fig. 3

Fig. 4

Fig. 5

Fig. 6

Fig. 7

Fig. 8

**IN DER BESCHREIBUNG AUFGEFÜHRTE DOKUMENTE**

**In der Beschreibung aufgeführte Patentdokumente**

- DE 8428975
- DE 8428975 U